# EUROPEAN PATENT APPLICATION

(11) **EP 3 205 932 A1**
(43) Date of publication of application: **16.08.2017**
(21) Application number: 17154334.1
(22) Date of filing: 02.02.2017
(51) Int. Cl.: F21V 23/00, F21L 4/00, F21V 23/04, F21Y 115/10, F21W 131/109

(54) **REUSABLE LED LANDSCAPE TOOL AND METHOD**

(30) Priority: 10.02.2016 US 201614998497; 22.09.2016 US 201615330451
(71) Applicant: The Patent Store LLC, O'Fallon, MO 63366 (US)
(72) Inventor: KING JR., L. Herbert, Chesterfield, MO 63005 (US); KEEVEN, James, O Fallon, MO 63368 (US); HINER, William, O Fallon, MO 63366 (US)
(74) Representative: Modiano, Gabriella Diana

(57) **Abstract**

A reusable LED landscape light set up tool (10) and method for either positioning, repositioning or illumination of a LED landscape light with a DC power source (19) and without hardwiring the LED landscape light prior to an attachment of the LED landscape light to a permanent power source.

## Description

### CROSS REFERENCE TO RELATED APPLICATIONS

This is a continuation in part of U.S. application Serial Number 14/998,750 filed February 10, 2016 titled Battery Powered Led Set Up Stand.

### STATEMENT REGARDING FEDERALLY SPONSORED RESEARCH OR DEVELOPMENT

None

### REFERENCE TO A MICROFICHE APPENDIX

None

### BACKGROUND OF THE INVENTION

One of the more popular light displays uses LED landscape lights, which typically may be arranged in a temporary holiday yard display or in a more permanent landscape light display. In either case the LED landscape lights need to be positioned based on the illumination effects on the landscape, which may not be evident until a nighttime illumination of the LED landscape lights. Consequently, the proper positioning of the landscape lights oftentimes becomes a trial and error process with the lights moved or adjusted until a satisfactory result is obtained.

One of the features of LED landscape lights is the low voltage, i.e. typically 24 volts or less, which makes it feasible for a non-electrician to install LED landscape lights. While the low voltage makes it possible for a homeowner or other non electricians to install a set of landscape lights the visual effect of the lighting is usually not realized or appreciated until after the LED landscape lights have been installed and illuminated. Consequently, the LED landscape lights may need to be repositioned to achieve the desired visual appearance. Typically, during set up the LED landscape lights are hard wired to a low voltage electrical cord extending from a transformer. In some cases splices are made between the electrical cord and the wire leads from the LED landscape light and in other cases crimp connectors are used to pierce the insulation coating on the electrical cord to form the electrical connection between the electrical cord and the wires of the LED landscape light.

Thus, one of the difficulties with designing and setting up a LED landscape light display is that after the LED landscape lights are arranged in the desired pattern the field installer needs to connect each of the LED landscape lights to a power source in order to obtain the full visual effect of the light display, which allows one to observe and decide if any of the LED landscape lights should be relocated. Unfortunately, if there are a number of LED landscape lights that need to be rearranged it becomes time consuming for the installer to move and rewire each of the LED landscape lights until the proper LED landscape light arrangement is obtained. In addition to determine the full effects of the LED visual display typically requires an after dark viewing of the LED landscape lights, which means that the LED landscape lights, which are typically installed in the daytime, require the installer return at night to activate the LED landscape lights so the home owner or business owner can determine if the LED landscape lights produce the desired illuminative effect to the surrounding area. If the location of the LED landscape lights does not produce the proper illuminative effect one needs to relocate the LED landscape lights. The relocation of an LED landscape light that has been spliced to the permanent power cord requires removing the electrical junction between the LED landscape light and the electrical cord and repairing the electrical cord where the splice occurred. The LED landscape light is then moved to a different location where the wires from the LED landscape light are attached at a different location along the power cord.

The invention described herein allows an installer to quickly and on-the-go set up, arrange or rearrange an LED landscape light within an LED yard display without having to wire or rewire the LED landscape lights each time a LED landscape light in the light display is moved, or replaced.

### SUMMARY OF THE INVENTION

The invention comprises a portable, battery power pack and control module with quick connect leads or a LED set up stand with quick connect leads that can be used by a field installer to create a low voltage LED yard display through an on-the-go field placement of individual LED landscape lights within an LED yard display. The invention enables one to temporarily power a low voltage LED landscape light without having to hard wire the LED landscape light to a permanent power source. The LED set up stand or the battery power pack with the control module can power an LED landscape light as the installer locates or relocates an LED landscape light in the LED yard display without the installer having to wire or rewire the LED landscape light each time an LED landscape light is relocated. The LED set up stand having a first extension for connection to one of a set of interchangeable support bases to enable mounting or attachment of the LED set up stand to different types of surfaces. The LED set up stand including a second extension for temporarily supporting a variety of LED landscape light products thereon with the LED set up stand carrying an internal low voltage replaceable DC power source for powering an LED landscape light product secured thereto during an on-the-go creation of an LED yard display through a process of on-the-go locating and relocating of LED landscape lights within the LED yard display. While the battery powered set up stand or the battery power pack with the quick connect leads and the control module are both ideal for creation of long term LED displays either may also be used to power an LED landscape light in those displays which are used intermittently. Since the powered consumed by an LED landscape light is minimal the battery powered set up stand or the battery power pack may be used to quickly and efficiently create a temporary LED landscape light display which eliminates the time and costs occurred in installing permanent wiring for an LED landscape light display.

### BRIEF DESCRIPTION OF THE DRAWINGS

Figure 1 is a perspective view of the portable battery powered LED set up stand attached to a flat bottom support base;
Figure 2 is an isolated side view of the flat bottom support base of Figure 1;
Figure 3 is a front view of an additional support base comprising a flat blade stake for soil engagement;
Figure 3A is a side view of the flat blade stake of Figure 3;
Figure 4 is a side view of the portable battery powered LED set up stand revealing a battery compartment and a LED landscape light mounted to a top side of the LED set up stand;
Figure 5 is a side view of a laser light mounted on the portable battery powered LED set up stand with a flat blade stake for temporary soil support of the laser light; and
Figure 6 is an exploded view of the portable battery powered LED set up stand with a coupling and pole for vertically position an LED landscape light during arrangement of a light display;
Figure 7 is a perspective view of an intelligent LED set up stand comprising a control module for selective powering of the LED landscape lights prior to a permanent installation;
Figure 8 is a perspective view of a battery pack for powering an LED landscape light during field setup;
Figure 9 is an exploded perspective view of a rechargeable battery and a LED set up stand comprising a control module having an electrical connector for engagement with an electrical connector on the rechargeable battery;
Figure 10 is a perspective view of an LED landscape light with a stake mount with the light pivotable for illuminating areas in trees or the like;
Figure 11 is a perspective view of a tube type LED landscape light that is typically ground mounted;
Figure 12 is a side view of a dome type LED landscape light that is used to direct light downward;
Figure 13 is a top view of a portion of a yard showing the possible locations of the an LED landscape light in relation to a power code; and
Figure 14 is a perspective view showing a set of battery packs and control modules powering a set of LED landscape lights.

### DESCRIPTION OF THE PREFERRED EMBODIMENT

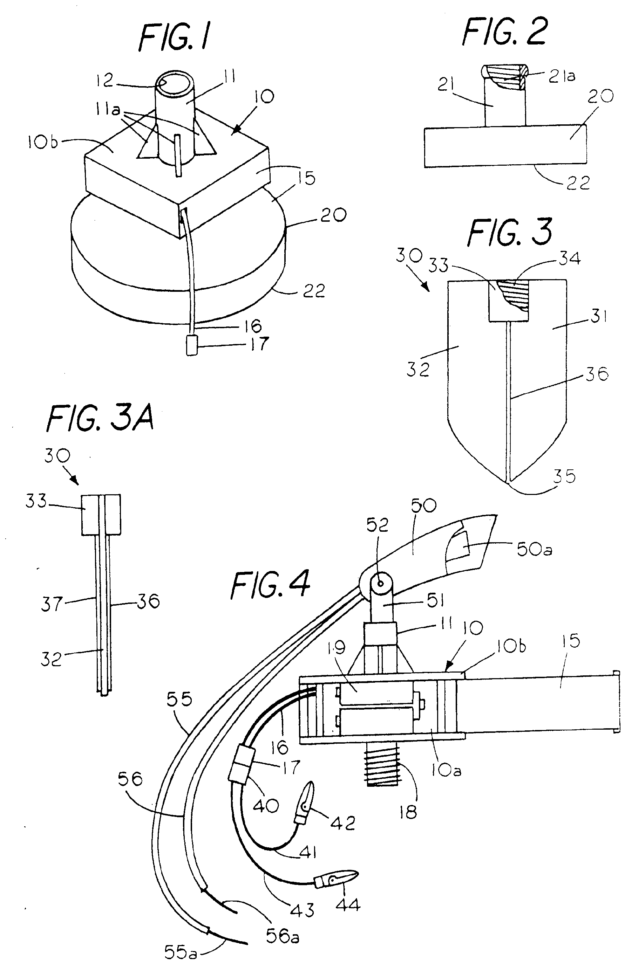

Figure 1 is a perspective view of a portable battery powered LED set up stand 10, with the bottom of the set up stand 10 secured to the top of a flat bottom cylindrical support base 20 and Figure 4 shows the portable battery powered LED set up stand 10 with the top of the set up stand 11 connected to an LED landscape light base 51 in just one of the ways the versatility of the LED stand can be used to support and display LED landscape lights.

In the example of Figure 1 portable battery powered LED set up stand 10 comprises a rectangular shaped housing 10b with a female thread 12 in extension 11 for temporary threaded securement to the under side of an LED landscape light fixture. Extension 11 includes a set of radial fins 11 a for supporting the extension 11 in a vertical or upright orientation on a topside of housing 10b. LED set up stand 10 and extension 11 preferably comprise a lightweight polymer plastic with extension 11 having an internal thread 12 for temporary threaded engagement with a variety of LED landscape light fixtures that may be used in arranging a field display of LED landscape lights. LED set up stand housing 10b includes a sliding panel 15 that slides open to permit access to a battery compartment 10a located within the housing 10b (Figure 4). An electrical wire 16 with a two socket female connector 17 extends from the battery compartment within the LED set up stand 10 to supply DC power from batteries therein to a LED landscape light or the like that is secured to the set up stand 10 to provide a water resistant stand around the set of batteries therein. In the example shown the LED set up stand 10 is supported in an upright condition on a flat surface through a flat underside 22 of base 20. Preferably, base 20 is a high-density material that provides sufficient weight so that, the base 20, which extends beyond the edges of the LED set up stand, provides a stability that prevents accidental tipping the LED set up stand 10 during use.

Figure 2 is a partially sectional side view of the flat bottom circular support base 20 of Figure 1 revealing a hollow extension 21 extending from the top of the support base 20 with the extension 21 having a set of internal threads 21 a for temporarily engaging a threaded male extension 18 (Figure 4) on the bottom of LED set up stand 10. Support base 20 is well suited for supporting the LED set up stand on a solid surface or floor since the weighted mass of support base 20 provides stability without need for permanent or temporary attachment of the support base to a surface or floor. Preferably the base weighs more than the housing LED set up stand 10 and the LED landscape lights mounted thereon to enhance the field stability of the LED set up stand.

The field installer often must set up LED landscape light displays in a variety of different configurations and on a variety of different support surfaces, which can hinder set up of an LED landscape light display. A feature of LED set up stand 10 is that it provides the versatility to accommodate different support surfaces with the same LED set up stand through use of a set of interchangeable bases.

Figure 3 is a front view of an example of a second type of support base 30 and Figure 3A is a side view of support base 30 that can be temporarily secured to the LED set up stand 10 to provide stable support on soil surfaces. Support base 30 comprises a pointed stake that includes a first flat side blade 31 and a second flat side blade 32 joined by a central reinforcing rib 36 located between internal edges of blades 31 and 32. The end of blades 31 and 32 converge to an apex 35 for ease in soil penetration. That is, the support base 30 forms a pointed stake that can be hand forced into soil by the installer to temporarily support the LED set up stand 10 during the evaluation of an LED landscape light display.

After evaluation of the light display is completed the stake 40 and the LED set up stand 10 can be removed from the soil for reuse in another location and the LED landscape light can be permanently mounted and hardwired for part of a permanent LED display. Thus, a feature of the invention is that the field installer can use the LED set up stand with a variety of different support bases independent of the LED landscape light carried in the LED set up stand.

Figure 3 shows a top portion of stake 30 includes a hub 33 having a set of internal threads 34 for temporary threaded engagement of an extension 18 (Figure 4) on the bottom of the LED set up stand 10 that enables the LED set up stand 10 to be supported either by the stake 30, which can be forced into the soil, or the base 20 of Figure 2, which can be placed on a flat surface. That is, stake 30 and base 20 are interchangeable with each other so that a user can select one or the other to mount to the underside of set up stand 10. Thus, a field installer can support the LED set up stand 10 in different field conditions by merely engaging the lower threads 18 on the set up stand 10 with an appropriate base. A feature of the invention is size and shape of the LED set up stand and the support bases are sufficiently large and hand graspable so the filed installer can through hand grasping and without the aid of tools attach or remove an LED landscape light or a support base from the LED set up stand. Consequently, the selection of the appropriate support base from a set of support bases can be determined on-the-go and set up without hand tools during an LED setup phase by the field installer.

Figure 4 is a side view of LED set up stand 10 revealing a sliding door 15, which slides on guides or rails within the housing (not shown) to provides access to a battery compartment 10a with a set of batteries 19 therein. Typically, the low voltage source in the LED set up stand comprise eight 1.5 volt dry cell batteries, which are connected in series to deliver 12 volts although higher or lower low voltage sources may be used. A sliding battery door 15, which is shown in the open condition in Fig. 4, permits access to the batteries 19 in the battery compartment 10a for quick replacement of spent batteries. A feature of the invention described herein is that the batteries need not be replaced for many hours since the present invention take advantage of the current consumption of an LED landscape light being low. A further feature is that the use of a low voltage power source avoids safety problems that can occur with 120 volt power sources, which may be reduced to a lower voltage, since the LED landscape light set up stand 10 can eliminate the presence of harmful 120 volts during the setting up of the LED display.

In the example of Figure 4, which is partially in section, an LED landscape light 50a mounts in a shroud 50 with the shroud 50 pivotally mounted to support 51, which has a lower end threaded into the female threads 34 in top extension 11 on LED set up stand 10. The pivotal mounting permits one to adjust the angular orientation of the LED landscape light on-the-go.

Extending from LED landscape light 50a is a first low voltage electrical lead 55 having a bared end 55a and a second low voltage electrical lead 56 having a bared end 56a, which are used to power the LED landscape light 50a located in shroud 50.

In order to power the LED landscape light 50a through the LED set up stand 10 there is provided an electrical cord 16 and a female connector 17, which connects to the batteries 19 in the LED set up stand 10. In this example a male connector 40 connects to female connector 17 with a male connector 40 having a first electrical lead 41 with a first alligator clip 42 attached thereto for forming a first temporary electrical connection to bared wire 56a and a second electrical lead 43 having a second alligator clip 44 attached thereto for forming a second temporary electrical connection to bared wire 55a to provide low voltage DC power to illuminate the LED landscape light 50. Thus, a feature of the LED self-powered set up stand is that LED set up stand can be independently positioned of other LED landscape lights with the LED landscape light on the LED set up stand and powered independently of other LED landscape lights by connecting each of the alligator clips 44 and 42 to the electrical leads 55a and 56a of the LED landscape light 50a. Conversely, if one wants to determine how the light arrangement would appear without the LED landscape light 50a one can merely disconnect one of the alligator clips 42 or 44 to depower the LED landscape light 50a. While quick clip connectors such as alligator clips are preferred other types of connections may be used without departing from the spirit and scope of the invention.

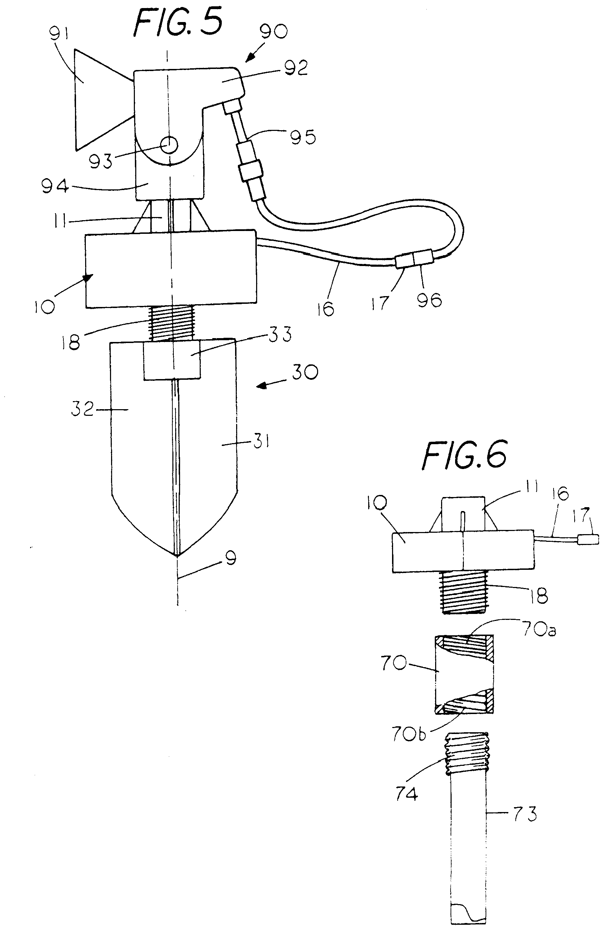

Figure 5 is a side view of the LED set up stand 10 in combination with a support stand 30 attached to the underside of stand 10 and a light 90 attached to the top of set up stand 10. In this example a laser light 91 mount on the LED set up stand 10 with a support base comprising a flat blade stake 30 that is threadingly engaged with a lower threaded extension 18. Stake 30 allows one quickly and easily provide the LED set up stand with soil support. The example of Figure 5 illustrates the first extension 11 and the second extension 30 are located along a common axis 9, which enhances the stability of the LED set up stand during the placement and evaluation of an LED landscape light display.

Figure 5 shows the LED set up stand 10 has the top cylindrical extension 11 supporting a different LED housing 94 having a pivotal pin 93 for pivotally supporting housing 92 thereon. In this example a laser light 91 is attached to housing 92 through an electrical connection such as a socket connection (not shown). An electrical lead 95 from light 91 includes a male electrical connector 96 that connects to female connector 17 for temporary powering of laser light 91 as the visual appearance of a laser light arrangement is evaluated. In this example to power or depower light 91 one merely connects or disconnects female connector 17 and male connector 96. Figure 5 illustrates the versatility of the LED set up stand 10 since it can accommodate different LED landscape lights as well as different types of electrical connections, a feature appreciated by the person setting up the field display.

While the support base 20 and 30 are used for mounting the LED set up stand on a support surface the set up stand 10 includes a further support base that permits vertical positioning of an LED landscape light. Figure 6 shown an exploded view of the LED set up stand 10 with another type of support base with the support base including a female coupling 70 and a pole 73 having a threaded end. In this embodiment the coupling 70 has a first set of threads on one end that matches the threads on extension 18 on the LED set up stand 10 and a second set of threads 70b on the opposite end that matches the threads typically found on a broom handle or the like, which is usually 5 or less threads per inch. A feature of the support shown in Figure 6 is a pole or convention broom handle 73 can be used to vertically support or position the LED set up stand 10. The pole 73 enables a person to elevate or lower the LED so the LED landscape light can be viewed in different positions as part of the process of setting up an LED landscape design. Thus, the invention enables both vertical and horizontal temporary positioning of LED landscape lights to allow the installer to evaluate the most desirable location of the individual LED landscape lights in the light system. A further feature is that if desired, the lower end of the pole can be sharpened or fitted with a blade to allow the pole to hold the LED stand and the LED landscape light at an elevated condition.

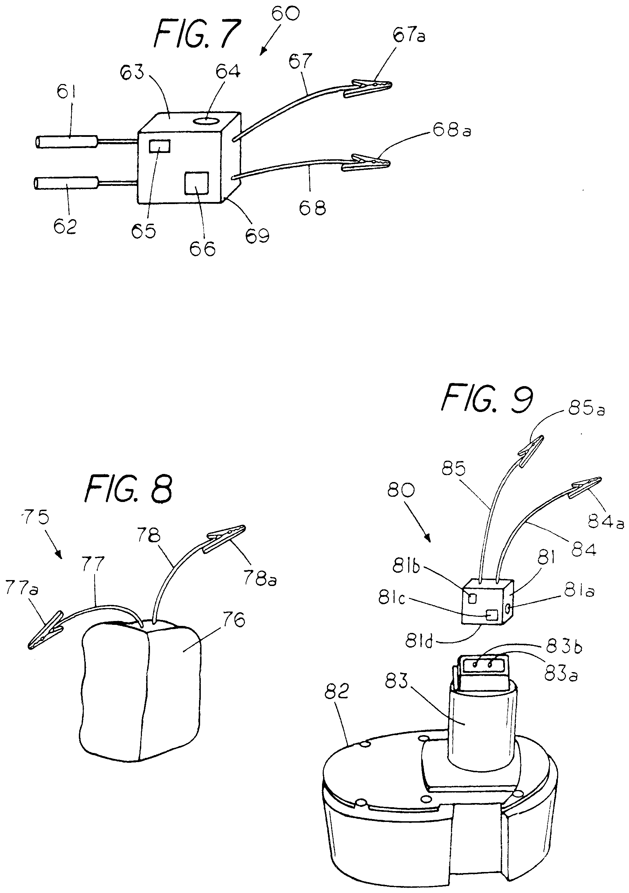

Figure 7 is a perspective view of a control module 60 with quick connecters 67a and 68a for selective powering of an LED landscape light when the terminals 61 and 62 are attached to the battery power pack 75 shown in Figure 8. In this example, control module 60 includes a housing 69 with a first electrical lead 61 for connecting to one pole of a battery and a second electrical lead 62 for connecting to another pole of the battery, which may for example be a 12 volt DC battery. Control module 60 includes a third electrical lead 67 with a quick connector 67a, such as an alligator clip, which is electrically engageable and disengageable with an input wire of an LED landscape light, and a fourth electrical lead 68 such as an alligator clip 68a, which is electrically engageable and disengageable with a further input wire of the LED landscape light for temporarily supplying power to the LED landscape light. In this example, control module 60 includes a manual or mechanical on/off switch 65 that an installer can use to turn on or off an LED landscape light, which is attached to leads 67 and 68. In addition to the manual switch 65 the control module 60 includes a remote control switch 66 that can also be used to turn the LED landscape light on or off. For example, the remote control switch 66 may be in wireless communication with either a smart phone or a separate remote, which provides the installer the ability to remotely turn on and off the LED landscape light in order to observe the effects of the LED landscape light on the LED display from a remote viewing area without having to physically be present at the LED landscape light.

A further feature of the remote control switch 66 is that if a plurality of control modules are used each remote control switch may be provided with a separate frequency, which allows individual LED landscape lights to be remotely turned on or off with the remote or a smart phone. The remote control feature allows a person to observe the effect of an LED landscape light without having to manually activate a switch at the LED landscape light or be at the LED landscape light. A further feature of control module 60 is a timer switch 64 that allows the installer to set an on or off time or both for an LED landscape light. For example, the installer may set an on time to occur half an hour after sunset, which allows for a daytime placement of the LED landscape lights in their initial landscape position and a later nighttime viewing of the LED landscape lights after the installer has left for the day. This allows the customer to view the LED landscape lights at his or her leisure to determine if the LED landscape lights produce the proper visual effect for the landscape. The installer can then be called back to either hard wire the LED landscape lights in place or change the position of the LED landscape lights. Once the customer is satisfied with the location of the LED landscape lights the installer disconnects the DC power from each light, while leaving the LED landscape light in position. The installer then completes the permanent wiring of the LED landscape lights by hardwiring each of the LED landscape lights to an AC electrical power cord that typically extends from a transformer connected to the conventional 110 voltage power line. The timer switch 64 may include a photo cell, which may be used to control the illumination of the LED landscape lights.

While the control module 60 has been described with a manual switch 65, a timer switch 64 and a remote control switch 66 that is responsive to a wireless signal any, all or none of the features may be incorporated into the control module 60 without departing from the spirit and scope of the invention.

Figure 8 shows a perspective view of a DC battery pack 75 that includes an exterior casing 76 with a first electrical lead 77 having one end connected to the positive terminal of the battery pack 75 and the opposite end containing an alligator clip 77a for quick attachment to a first electrical lead of an LED landscape light and a second electrical lead 78 having one end connected to either the negative terminal of the battery pack 75 and the opposite end containing an alligator clip 78a for quick attachment to a second electrical lead of an LED landscape light for the temporary powering of an LED landscape light. While in this example the alligator clips are attached to the battery leads in some instances the wire leads of the LED landscape light may be directly connected to the negative and positive terminals of a DC battery thus eliminating the need for electrical leads on the battery. In the example of Figure 8 the power from the dc battery 76 to a set of LED landscape light leads may be controlled by connecting or disconnecting quick connectors 77a and 78a, which in this example comprise alligator clips, however, other types of connectors may be used without departing from the spirit and scope of the invention.

In still other examples the installer may rely on twisting an end of a first flexible wire from the battery with an end of a first flexible wire from the LED landscape light and twisting an end of a second flexible wire from the battery with and an end of a second flexible wire from the LED landscape light to form twisted junction electrical connections between the battery and the LED landscape light. Preferably, the length of the wires from the battery 76 or the LED landscape light are sufficiently long so that the battery 76 can be placed on the ground proximate the LED landscape light and temporarily connected to the LED landscape light without imparting strain to the electrical connections therebetween. In each case a DC battery powers the LED landscape light during the initial set up of the LED yard display.

Figure 9 shows an exploded view of a control module 81 with a rechargeable DC battery 82. In this example control module 81 has a first lead 85 with a quick attachment connector 85a and a second lead 84with a second quick attachment connector 84a, which are hand or finger engageable with the electrical leads on an LED landscape light or the like. Although alligator connectors are shown other types of connectors may be used without departing from the spirit and scope of the invention. Control module 81 is similar to control module 60 in that the control module 81 includes a manual mechanical on/off switch 81b that an installer can use to turn on or off an LED landscape light, which is attached to leads 84 and 85. In addition to the manual switch 81b the control module 81 includes a remote control switch 81c that can also be used to turn the LED landscape light on or off with a remote or smart phone. Control module 81 includes a timer switch 81 a that allows the installer to set the on or off time or both for an LED landscape light attached thereto. In this example the control module 81 includes a female connector 81d for forming an electrical connection with the terminal 83a and 83b on post 83 of a rechargeable DC battery 82. In this example the rechargeable DC battery 82 is the type typically used for powering hand tools, a convenience which allows the installer to use the power charger for the power tools to charge the DC battery that is used to temporarily power an LED landscape light during a light evaluation of the LED landscape lights.

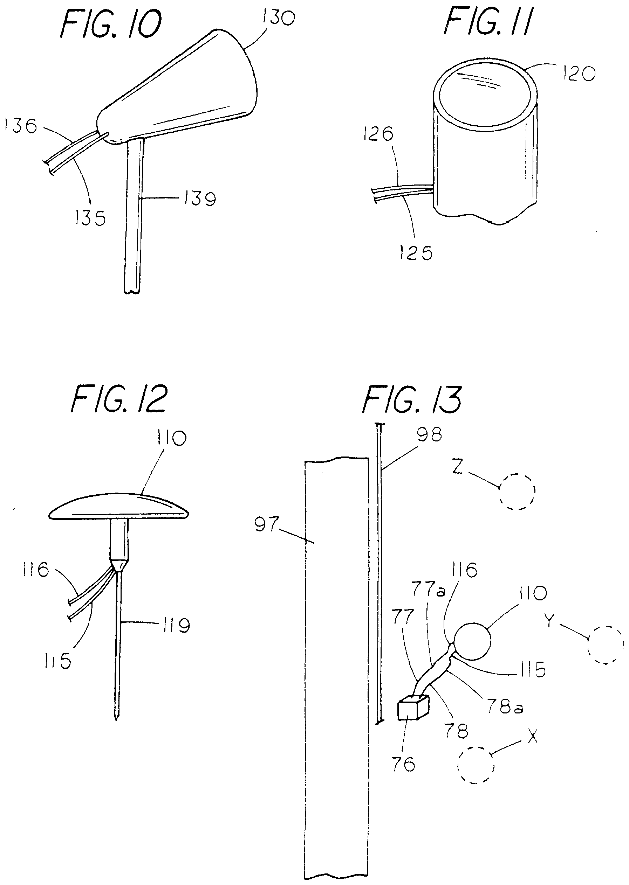

Figures 10, 11 and 12 illustrate examples of typical LED landscape lights that may be installed and temporarily powered by the invention described herein although other types of LED landscape lights may also be temporarily powered by the invention described herein.

Figure 10 a perspective view of an example of cone shrouded LED landscape light 130 with a stake 139 for pushing into the ground with the cone shrouded LED landscape light 130 pivotable for illuminating areas in trees or the like. A first flexible electrical lead 136 and a second flexible electrical lead 135 extend from light 130 for powering the LED landscape light 130. Typically, these are the leads that are part of the LED landscape light and will be first used to temporarily power the LED landscape light by attachment to a DC source and to later more permanently power the LED landscape light by attachment to an AC power source.

Figure 11 is a perspective view of another example of an LED landscape light 120 that is typically ground mounted with LED landscape light 120 having a first electrical lead 125 and a second electrical lead 126 for powering LED landscape light 120.

Figure 12 is a side view of another example of an LED landscape light 110. LED landscape light 110 is a dome type that is used to direct light downward and includes a stake 119 for ground insertion as well as electrical leads 115 and 116 for connecting to a power source. In each of the examples the LED landscape lights include a set of electrical leads that need to be connected to a power source in order to illuminate the LED landscape lights.

Figure 13 is a top view of a yard revealing a sidewalk 97 and an electrical power cord 98 extending along the sidewalk. In this example a set of LED landscape lights will eventually be permanently connected to the power cord 98 in order to supply power thereto. In this view a single LED landscape light 110, which is powered by DC battery pack 76, is located in a first position proximate sidewalk 98 with LED landscape light 110 powered solely by battery 76. To illustrate the benefit of the invention three different locations x, y, and z have been identified for possible locations of the LED landscape light 110. If the LED landscape light were to be repositioned in either position x, y, or z the length and position of the wire from the LED landscape light to the power cord 98 would need to be changed, which requires rewiring the LED landscape light each time the LED landscape light is moved. With the invention described herein one can move the LED landscape light 110 from position x to position y or to position z without having to attach LED leads 115 and 116 to the permanent power cord 98 since the battery pack 76 can be moved with the LED landscape light 110. Once the final location of the LED landscape light 110 is determined the installer disconnects the battery pack 76 from the LED landscape light leads 115 and 116 and then connects the LED landscape light leads 115 and 116 to the permanent electrical power cord 98, which is typically connected to a transformer on a house or building power line. Thus, as described herein a DC battery is used to power the LED landscape light during set up and an AC power source is used to power the same LED landscape light after the LED landscape light is permanently mounted in the yard display.

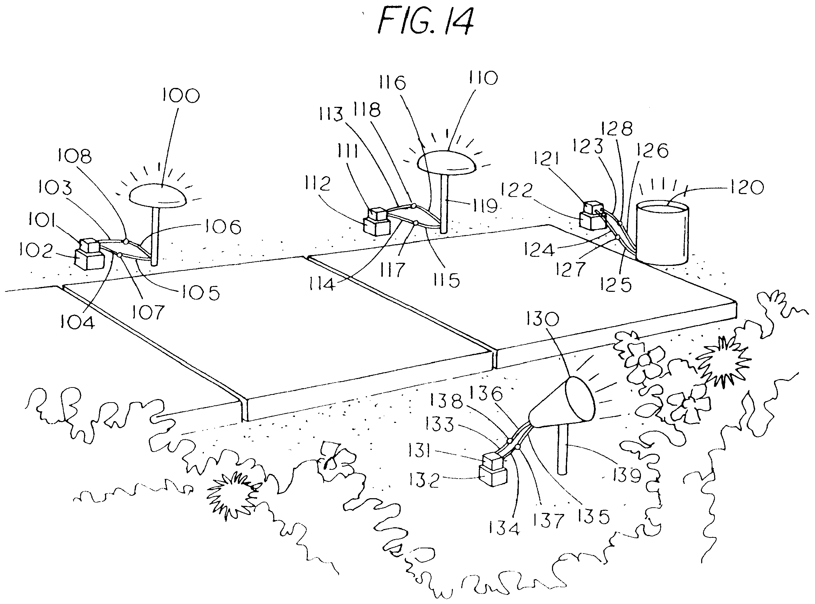

Figure 14 is a yard display 150 showing the temporary placement of four different types of LED landscape lights with each LED landscape light including a control module and a power pack for illuminating the LED landscape light. That is, LED landscape light 100 includes a first electrical lead 106 that connects to control module 101 and battery pack 102 through a quick connector 108 an electrical lead 103 and a second electrical lead 105 that connects to control module 101 and battery pack 102 through a quick connector 107 and an electrical lead 104. The use of the battery pack 102 and control module 101 allows the LED landscape light to be moved from one location to another and illuminated without having to connect the LED landscape light 100 to a permanent power source. Typically, electrical leads as described herein may be flexible wires with an electrical insulation cover and an end where the insulation is removed for making electrical contact with a solid or stranded wire core therein.

Similarly, LED landscape light 110 includes a first electrical lead 116 that connects to control module 111 and battery pack 112 through a quick connector 118 and lead 113 and a second electrical lead 115 that connects to control module 111 and battery pack 112 through a quick connector 117 and a lead 114. Likewise, LED landscape light 120 includes a first electrical lead 126 that connects to control module 121 and battery pack 122 through a quick connector 128 and lead 123 and a second electrical lead 125 that connects to control module 121 and battery pack 122 through a quick connector 127 and a lead 124. LED landscape light 130 includes a first electrical lead 136 that connects to control module 131 and battery pack 132 through a quick connector 138 and lead 133 and a second electrical lead 135 that connects to control module 131 and battery pack 132 through a quick connector 137 and a lead 134.

Figure 14 shows how a set of LED landscape lights 100, 110, 120 and 130 can be temporarily powered by a battery pack and control module, which allows a viewer to turn on or off an LED landscape light or to move the LED landscape lights to a different location without having to rewire the LED landscape lights. Thus, a set of DC battery packs or DC battery packs and control modules become an on-the-go design tool for an installer to arrange lights for viewing and at the same time eliminate problems in rewiring the LED landscape lights in the event the LED landscape lights are moved.

Thus, a feature of the invention is an installer friendly method of LED set up and temporary viewing of an LED landscape light display without the necessity to hard wire the LED landscape lights. Typically, an operator may form a set of stand alone components by attaching an LED landscape light to a self-powered LED set up stand having a support base or to a battery pack or to a control module connected to a battery pack. The operator than has the ability to form a LED landscape light arrangement using numerous LED set up stands or battery packs. In one example the operator places the first powered set up stand in a first location and further self powered set up stands in other locations to complete the LED landscape light layout without having to hardwire any of the LED landscape lights. In the next step the operator illuminates each of the LED landscape lights on the self powered set up stands using the dc power source on the self powered set up stand. Once powered the operator can view the LED landscape light display to determine if any of LED landscape lights should be removed or rearranged, which the operator can do without having to connector or disconnect the LED landscape lights since each of the LED set up stands contain their own power source. During the set up process some of the self-powered set up stand can be mounted on a flat bottom base and others can be mounted on a stake while others may be mounted on a pole.

A further feature of the invention is that one can replace an LED landscape light on a self-powered set up stand with a different LED landscape light, for example a different color LED. In addition the method may include the step of powering at least one of the LED landscape lights through a temporary electrical connection from the self powered LED set up stand and electrical leads from the LED landscape light.

A further feature is that one can replace the dry cell batteries in the first powered LED set up stand with a fresh set of dry cell batteries, which preferably may be AA dry cell batteries, which are commercially available and inexpensive.

In one mode the invention may comprise a reusable LED landscape light tool for positioning, repositioning and illumination of a LED landscape light illuminatively responsive to either AC or DC voltage without hardwiring the LED landscape light to a permanent power source prior to a permanent installation of the LED landscape light comprising:
a DC battery having a DC voltage output;
a first electrical lead connected to a negative pole of the DC battery and to a LED landscape light located in a LED yard display; and
a second electrical lead connected to a positive pole of the DC battery and to the LED landscape light located in the LED yard display for DC powering the LED landscape light during an installation phase of an LED yard display.

Further modifications to the invention may a LED landscape light control module with the control module connected to a DC battery and to an LED landscape light and an on/off switch on the LED landscape light control module for controlling delivery of the DC voltage output to a pair of electrical leads on the LED landscape light control module with each of the pair of electrical leads having a quick connector thereon.

The LED landscape tool may include a timer on the LED landscape light control module for setting an on time for delivery of the DC voltage output from the control module to a pair of LED electrical leads each having a quick connector thereon.

The LED landscape light tool may include a remote control on the LED landscape light control module with the remote control responsive to a remote operator signal to thereby control the delivery of the DC voltage from the control module to a pair of LED electrical leads each having a quick connector thereon.

The reusable LED landscape light tool including flexible electrical leads and a control module with a photocell for powering the control module.

The reusable LED landscape light tool may include a control module responsive to a remote controller for wireless on/off control of a LED landscape light connected to the control module.

One of the features of the invention is a method of temporary illumination of a low voltage LED landscape light in a yard display containing a set of low voltage LED landscape lights during an LED landscape light installation phase comprising the steps of:
arranging the set of low voltage LED landscape lights in the yard display without connecting the set of low voltage LED landscape lights to a power source with a low voltage LED landscape light of the set of low voltage LED landscape lights having a set of electrical leads;
forming an electrical circuit between a DC battery and the set of electrical leads on the low voltage LED landscape light to illuminate the low voltage LED landscape light;
disconnecting the DC battery from the low voltage LED landscape light after either relocating the low voltage LED landscape light in the yard display or after allowing the low voltage LED landscape light to remain in position in the yard display; and
permanently wiring the set of electrical leads of the low voltage LED landscape light to a permanent power source to provide power to illuminate the low voltage LED landscape light.

The method may include the following steps:
closing the electrical circuit with a either a timer or a remote wireless switch;
connecting a further DC battery of to a further low voltage LED landscape light in a set of low voltage LED landscape lights.
placing a set of LED landscape lights at different locations and powering each of the set of LED landscape lights with a portable DC battery to determine a first visual effect of the LED landscape lights and then repositioning at least one of the set of LED landscape lights without disconnecting a DC battery power connected to the at least one of set of LED landscape lights to determine a second visual effect; and
disconnecting the portable DC battery from each of LED landscape lights in the set of LED landscape lights and hard wiring each of LED landscape lights in the set of LED landscape lights into an AC power source.

Further modifications may include the step of forming an electrical circuit between a DC battery and the low voltage LED landscape light comprises forming an electrical circuit between a DC battery of less than 50 volts and the low voltage LED landscape light.

In other examples a portable LED set up stand for temporary arranging and maintaining a LED yard display for on-the-go evaluation of the LED yard display may comprise;
a housing;
a set of dc dry cell batteries carried in the housing;
a first extension from a top side of the housing for temporary securement of an LED light thereto;
a second extension on the housing;
a first electrical lead for forming a first temporary electrical connection extending from a negative pole of the set of dc dry cell batteries in the housing;
a second electrical lead for forming a second temporary electrical connection extending from a positive pole of the set of dc dry cell batteries in the housing; and
a support base connected to the housing to maintain a fixed orientation of an LED light during an evaluation of the LED yard display containing the LED light.

In one example a set of dc dry cell batteries comprises eight 1.5 volt batteries are used to power the stand.

The LED set up stand may include a first extension that includes an LED socket and the second support base extension on the opposite side of the housing that are located in axial alignment with each other.

Other features of the LED set up stand of claim include a coupler for attachment to the second extension on the LED set up stand and the coupler has a female thread of a first pitch on one end for engaging the LED set up stand and a female thread of a different pitch on the other end for engaging a support base.

The LED set up stand may include a first alligator clip and a second alligator clip for temporary powering an LED light on the LED set up stand connected to the set of dry cell batteries and the set of dc dry cell batteries are AA batteries and the extension on the top of the housing and the bottom of the housing are located axially opposite of each other.

Further modification to the method including the step of replacing an LED light on either the first self powered LED set up stand or the further LED setup stand with a different LED light or powering at least one of the LED lights through a temporary electrical connection from the self powered set up stand and an electrical lead from the LED light and replacing a set of dry cell batteries in the first powered set up stand with a fresh set of dry cell batteries.

## Claims

1. A reusable LED landscape light set up tool for positioning, repositioning and illumination of a LED landscape light during an LED landscape light installation phase without hardwiring the LED landscape light to a permanent power source prior to a permanent installation of the LED landscape light comprising:
a LED landscape light control module having a first electrical lead with a first quick connector thereon electrically engageable disengageable with a first electrical LED landscape light lead and a second electrical lead with a second quick connector thereon electrically engageable and disengageable with a second electrical LED landscape light lead for illuminating an LED landscape light attached thereto;
a DC battery connected to said LED landscape light control module with said DC battery having a DC voltage output of less than 50 volts DC;
an on/off switch on said LED landscape light control module for controlling a delivery of the DC voltage to said first quick connector and said second quick connector;
a timer on said LED landscape light control module for setting an on time for delivery of the DC voltage from the control module to said first quick connector and said second quick connector; and
a remote control on said LED landscape light control module with said remote control responsive to a remote operator signal to thereby control the delivery of the DC voltage from the control module to said first quick connector and said second quick connector.

2. The reusable LED landscape set up tool of claim 1 wherein the timer on the LED landscape light control module controls both the on time and an off time.

3. The reusable LED landscape set up tool of claim 1 wherein the first quick connector is an alligator clip.

4. The reusable LED landscape set up tool of claim 1 wherein the DC battery comprise a rechargeable DC battery.

5. The reusable LED landscape set up tool of claim 4 wherein the LED landscape light control module includes an electrical connector for frictionally engaging a set of electrical leads on the rechargeable DC battery.

6. The reusable LED landscape set up tool of claim 4 wherein the rechargeable DC battery includes a post supporting the set of electrical leads on the rechargeable DC battery.

7. A portable battery powered LED set up stand for temporary arranging, viewing and on-the-go evaluation of a LED yard display comprising:
a housing having a compartment therein;
a dc voltage source located in said compartment;
a first extension comprising a socket extending from a first side of said housing with said socket having an internal thread for temporary securement of an LED light fixture thereto;
a second extension extending from the opposite side of said housing with said second extension having a set of external threads for attachment to a base;
a first electrical lead having a first end connected to a positive side of the dc voltage source and a second end having an alligator clip for forming a first temporary electrical connection;
a second electrical lead having a first end connected to the negative side of the dc voltage with a second end having a second alligator clip for forming a second temporary electrical connection; and
a support base connected to said second extension for maintaining a fixed orientation of the LED set up stand during the evaluation of the LED yard display.

8. The portable LED set up stand of claim 7 wherein the support base is removably attached to the extension of the LED set up stand with the support base holding the LED set up stand in an upright condition.

9. The portable LED set up stand of claim 7 wherein the support base comprise a blade having a first end for soil insertion and a second end for threaded engagement with the second extension to temporarily maintain an LED light in the set up stand in a viewable condition.

10. The portable LED set up stand of claim 7 including a female coupling having a first end with a female thread greater than 5 thread per inch for engaging a thread on the second extension and a second end with a second thread for engaging a broom handle wherein the pitch on thread for engaging the broom handle is 5 or less threads per inch.

11. A method of setting up a temporary viewing an LED light display without hard wiring a set of LED lights comprising the steps of:
attaching a first LED light of the set if LED lights to a self powered LED set up stand having a support base;
attaching a second LED light of the set if LED lights to a further self powered LED set up stand having a support base;
placing the first powered LED set up stand in a first location and the further self-powered LED set up stand in a second location;
illuminating the LED light on the first self powered LED set up stand using a dc power source within the self powered LED set up stand and the LED on the further self powered LED set up stand using a dc power source within the further self powered set up stand; and
viewing the LED light display with the first LED light and the second LED light to determine if either of the first LED light or the second LED light should be removed or rearranged.

12. The method of claim 11 including the step of mounting the self powered LED set up stand on a flat bottom base.

13. The method of claim 11 including the step of mounting the further self powered LED set up stand on a stake.

14. The method of claim 13 including the step of replacing an LED light on either the first self powered LED set up stand or the further LED setup stand with a different LED light.

15. The method of claim 11 the step of attaching a pole to a housing of the first self powered LED set up stand and elevating the self powered set up stand and the LED light thereon to provide a different visual arrangement of LED lights.
